# EUROPEAN PATENT APPLICATION

(11) **EP 2 530 750 A2**
(43) Date of publication of application: **05.12.2012**
(21) Application number: 12169693.4
(22) Date of filing: 29.05.2012
(51) Int. Cl.: H01L 33/50, H01L 33/58

(54) **Light emitting diode lens, light emitting diode module including the same and method for manufacturing the light emitting diode module with said lens**

(30) Priority: 31.05.2011 KR 20110051845
(71) Applicant: Samsung Electronics Co., Ltd., Suwon-si, Gyeonggi-do, 443-742 (KR)
(72) Inventor: You, Jae Sung, 442-828 Gyeonggi-do (KR); Song, Jong Sup, 443-794 Gyeonggi-do (KR); Oh, Sung Kyong, 441-400 Gyeonggi-do (KR)
(74) Representative: Grünecker, Kinkeldey, Stockmair & Schwanhäusser

(57) **Abstract**

An LED lens (100) according to an embodiment of the present invention includes a first depression (121) and a second depression (125) having predetermined patterns in a lower portion of the lens. A phosphor layer (460, 660) and the lens may be collectively formed by disposing the lens after spraying a phosphor (670) rather than separately forming the phosphor on the LED chip (440, 640) during a manufacture of the LED module. Accordingly, a production tolerance, and the like of an LED module may be removed to improve yield, and a manufacturing process of the LED module may be simplified. The lens may have an upper portion formed in advance in one of a hemispherical shape, an oval shape, and a batwing shape having a concave central portion, thereby implementing a customized lens according to a predetermined application.

## Description

### CROSS-REFERENCE TO RELATED APPLICATION

This application claims the priority benefit of Korean Patent Application No. 10-2011-0051845, filed on May 31, 2011, in the Korean Intellectual Property Office, the disclosure of which is incorporated herein by reference.

### BACKGROUND

### 1. Field of the Invention

The present invention relates to a light emitting device (LED) lens, an LED module including the LED lens, and method of manufacturing the LED module using the LED lens, and more particularly, to an LED lens, an LED module including the LED lens, and method of manufacturing the LED module using the LED lens that may improve yield of the LED module, simplify a manufacturing process of the LED module, and implement a customized lens according to a desired application

### 2. Description of the Related Art

A light emitting device (LED) is a semi-conductor light emitting apparatus that emits light when a current flows. The LED may have features of a long life-span, a low power consumption, a fast response speed, an excellent initial operation, and the like and thus, may be widely applied to a lighting device, a headlight and a courtesy light of a car, an electronic display board, a backlight of a display device, and the like. The number of fields that adapt the LED has increased.

Recently, the LED is used as a light source of various colors. As the demand for a high power and high luminance LEDs, such as a white LED for lighting and the like, increases, research for improving the performance and reliability of an LED package has been actively conducted. To improve the performance of an LED product, an LED package that effectively extracts light, that has an excellent color purity, and that has a uniform property among products may be needed in addition to an LED with an excellent optical efficiency.

Phosphors may be arranged on a blue LED or an ultraviolet LED to obtain a white light using the LED. The white LED may color-transform a portion of light extracted from the blue LED or the ultraviolet LED, based on a combination of a red phosphor, a green phosphor, a blue phosphor, and a yellow phosphor, and may provide a while light by mixing the phosphors. In addition to an efficiency that is the most important factor for determining the performance of the white LED, a color uniformity may also be important in terms of a color quality.

The LED may be manufactured as a package or a module so as to be a consumer product. The LED may be manufactured as an LED package by mounting an LED chip on a lead frame or a ceramic substrate, mixing and applying a phosphor suitable for a desired application, and molding a lens. Thereafter, the LED package may be cut to be a unit LED package and be mounted on a printed circuit board (PCB) to be modularized.

A structure that mounts the LED package on a PCB to be modularized may have a limit to miniaturization of an LED module, and may not decrease a price of the LED module due to a high rate of error occurring during at least two mounting processes. For instance, a luminance and a color of the LED package may have a deviation due to a deviation in a wavelength and a luminance of an LED, a manufacturing tolerance on an implement such as the lead frame, and a process tolerance on a phosphor coating process, a lens molding process, and the like.

Recently, a chip on board (COB) scheme in which an LED is directly mounted on a module substrate is used to manufacture the LED as a module rather than as a package. Multiple LEDs may be arrayed to generate a surface light source using an LED corresponding to a point light source. An LED module manufactured using the COB scheme in which multiple LEDs are directly mounted on a substrate may mount multiple LEDs on a module without a need for manufacture of a separate LED package and thus, the LED module may have an advantage in terms of a manufacturing cost.

However, a manufacturing process using the COB scheme may be complicated since phosphor layers may be separately formed on LED chips and lenses are disposed on each of the phosphor layers of the LED chips to generate a white light. The manufacturing process may be difficult since lenses are separately formed for each of the LED chips. Here, the lenses are used to increase a luminance flux and to overcome a difference in color temperature occurring during a conversion to a white light source through an LED chip and a phosphor layer.

Since lenses may be manufactured by separately spraying silicon on each LED chip, a diameter D of a lower surface of a lens and a height H of the lens may satisfy a relation of D = 0.7 × H. Consequently, upper surfaces of the lenses may be formed to be the same shape and thus, a lens conforming to a predetermined application may be difficult to be implemented.

### SUMMARY

Embodiments of the present invention provide an light emitting device (LED) lens, an LED module including the LED lens, and method of manufacturing the LED module using the LED lens that may improve yield of the LED module, simplify a manufacturing process of the LED module, and implement a customized lens according to an application.

According to an embodiment of the present invention, there is provided an LED lens including a first depression to receive a phosphor on an LED chip to form a phosphor layer surrounding the LED chip, and a second depression connected to the first depression and functioning as a passage for a portion of the phosphor to escape.

The first depression and the second depression may be formed in a lower portion of the LED lens, and an upper portion of the LED lens may be formed in one of a hemispherical shape, an oval shape, and a batwing shape having a concave central portion.

The first depression may be provided in a shape of one of a square cylinder, a cylinder, and a hemisphere.

Second depressions may be plural.

According to another embodiment of the present invention, there is provided an LED module, including a substrate having a cavity, an LED chip incorporated in the cavity, a phosphor layer surrounding the LED chip, and a lens including a first depression that receives a phosphor on an LED chip to form the phosphor layer and a second depression that is connected to the first depression and functions as a passage for a portion of the phosphor to escape.

The first depression and the second depression may be formed under the lens, and an upper portion of the lens may be formed in one of a hemispherical shape, an oval shape, and a batwing shape having a concave central portion.

The first depression may have be provided in a shape of one of a square cylinder, a cylinder, and a hemisphere.

According to still another embodiment of the present invention, there is provided a manufacturing method of an LED module, the method including forming a cavity on a substrate, mounting an LED chip in the cavity, spraying a phosphor on the LED chip, disposing a lens including a first depression, that receives the phosphor sprayed on the LED chip, and a second depression that is connected to the first depression and functions as a passage for a portion of the sprayed phosphor to escape, in the cavity, and curing the phosphor and the lens.

The curing may be performed at a predetermined temperature profile.

Second depressions may be plural.

### BRIEF DESCRIPTION OF THE DRAWINGS

These and/or other aspects will become apparent and more readily appreciated from the following description of embodiments, taken in conjunction with the accompanying drawings of which:
FIGS. 1A and 1B are diagrams illustrating a light emitting device (LED) lens according to an embodiment of the present invention;
FIGS. 2A and 2B are diagrams illustrating an LED lens according to another embodiment of the present invention;
FIGS. 3A and 3B are diagrams illustrating an LED lens according to still another embodiment of the present invention;
FIG. 4 is a diagram illustrating a portion of an LED module according to an embodiment of the present invention;
FIG. 5 is a diagram illustrating a portion of an LED module according to another embodiment of the present invention; and
FIGS. 6A through 6D are diagrams illustrating a method of manufacturing an LED module according to an embodiment of the present invention;

### DETAILED DESCRIPTION

Reference will now be made in detail to embodiments, examples of which are illustrated in the accompanying drawings, wherein like reference numerals refer to the like elements throughout. Embodiments are described below to explain the present disclosure by referring to the figures.

Throughout the specifications, when a description is provided in relation to a layer, a surface, a chip, and the like formed "on" or "under" a layer, a surface, a chip, and the like, the term "on" may include "directly on" and "indirectly on interposing another element therebetween," and the term "under" may include "directly under" and "indirectly under interposing another element therebetween." A standard for "on" or "under" of each element may be determined based on a corresponding drawing.

Sizes of elements in the drawings may be exaggerated for ease of descriptions, and does not indicate real sizes.

Hereinafter, a light emitting device (LED) lens, an LED module, and a method of manufacturing the LED module according to the present invention will be described with reference to drawings.

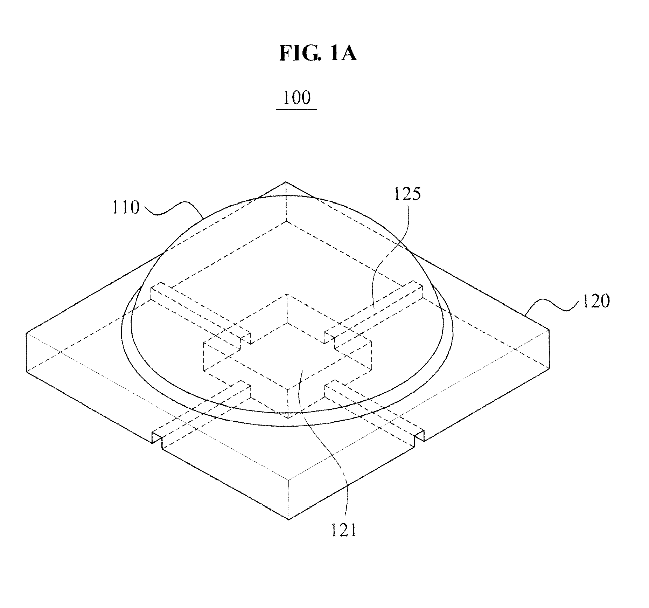

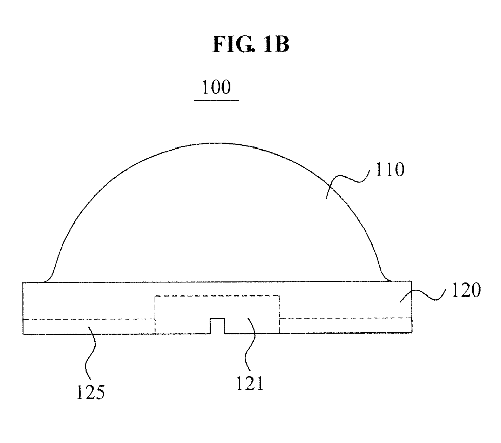

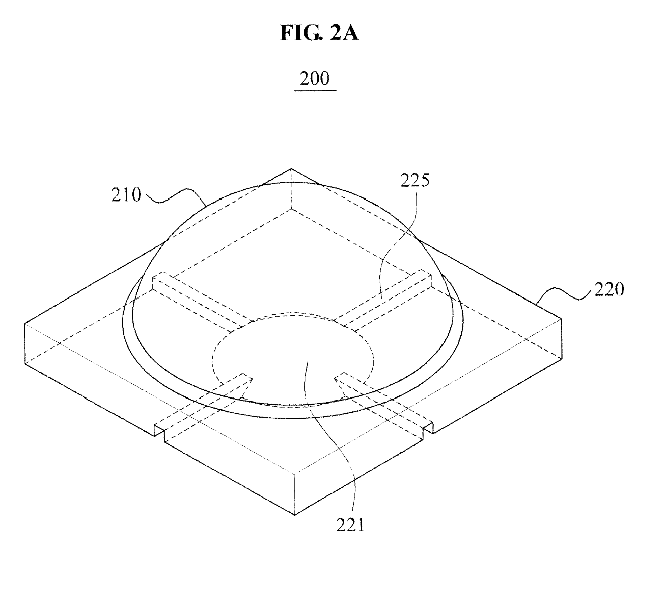

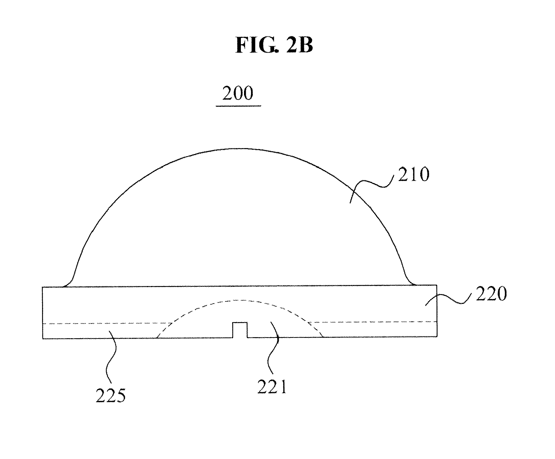

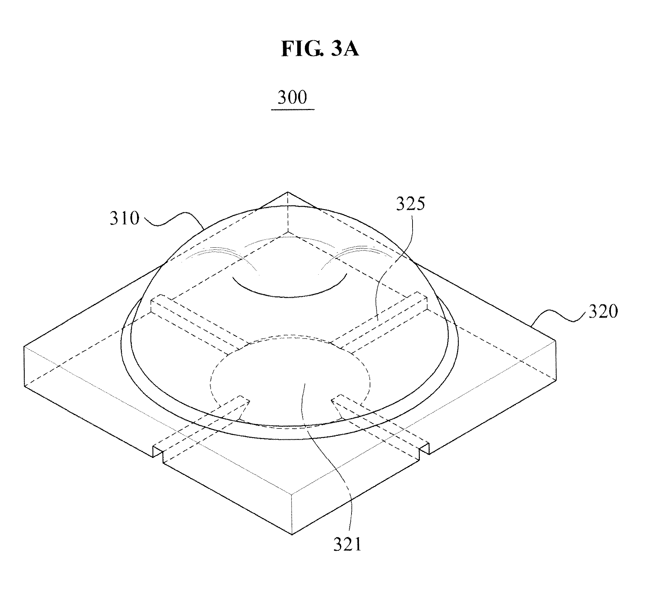

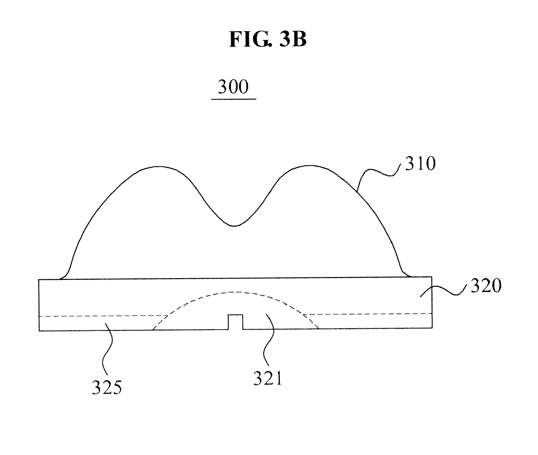

FIGS. 1A and 1B illustrate an LED lens 100 according to an embodiment of the present invention. FIGS. 2A and 2B illustrate an LED lens 200 according to another embodiment of the present invention. FIGS. 3A and 3B illustrate an LED lens 300 according to still another embodiment of the present invention.

Referring to FIGS. 1A through 3B, LED lenses 100, 200, and 300 according embodiments of the present invention may include first depressions 121, 221, and 321 and second depressions 125, 225, and 325 formed on lower portions 120, 220, and 320 of the LED lenses 100, 200, and 300, respectively.

A phosphor may be received in the first depressions 121, 221, and 321 and the second depressions 125, 225, and 325. Each of the first depressions 121, 221, and 321 may receive the phosphor on an LED chip to form a phosphor layer surrounding the LED chip. Here, the phosphor may be sprayed on the LED chip to be received. Each of the first depressions 121, 221, and 321 may be greater than the LED chip, and the phosphor layer may be formed in a space between each of the first depressions 121, 221, 321 and the LED chip.

A shape of the phosphor layer may vary depending on a shape of each of the first depressions 121, 221, and 321. The shape of each of the first depressions 121, 221, and 321 may be provided in the form of one of a square cylinder, a cylinder, and a hemisphere. Thus, the phosphor layer may be formed to surround the LED chip, and be formed in a shape corresponding to one of the first depression 121 of FIG. 1A and the first depression 221 of FIG. 2B.

When the phosphor layer is formed to have a uniform thickness and width on an upper surface and a side surface of the LED chip corresponding to the shape of the first depression 121 of FIG. 1A, a color dispersion may be reduced through a uniform conversion of light emitted from the LED chip. That is, when the phosphor layer is formed to have a same radius of curvature as a radius of curvature of an upper surface of one of the LED lenses 100, 200, and 300 such as the shape corresponding to the first depression 221 of FIG. 2A, a luminance flux of light emitted from the LED chip may be increased.

A shape of each of the first depressions 121, 221, and 321 may vary depending on a desired shape of the phosphor layer as it relates to various applications, and not be limited to the aforementioned shapes.

Herein, descriptions will be directed to the LED lens 100 of FIGS. 1A and 1B. However, the descriptions may be similarly applied to the LED lens 200 of FIGS. 2A and 2B and the LED lens 300 of FIGS. 3A and 3B. Thus, a description of the second depression 125 may be similarly applied to the second depressions 225 and 325, a description of the lower portion 120 may be similarly applied to the lower portions 220 and 320, and a description of an upper portion 110 may be similarly applied upper portions 210 and 310.

The second depression 125 may be connected to the first depression 121 and function as a passage for a portion of the sprayed phosphor to escape. The second depression 125 may function as a channel enabling an overflow of the phosphor from the first depression 121 to escape to an outside environment. A plurality of second depressions, for example, the second depression 125 may be formed to enable the overflow of phosphor to effectively disperse and escape.

The second depression 125 may be formed in a radial pattern centered at the first depression 121. The second depression 125 may radiate in a direction perpendicular to the first depression 121. The second depression 125 may radiate in a direction of a diagonal line of the first depression 121. The second depression 125 may not be limited to have the aforementioned shape, and be formed to have other shapes enabling an overflow of the phosphor from the first depression 121 to effectively escape.

The first depression 121 and the second depression 125 may be formed in the lower portion 120 of the LED lens 100, and the lower portion 120 of the LED lens 100 may be of a size that may be received in a cavity of a substrate. The lower portion 120 of the LED lens 100 may be formed to be smaller than the cavity of the substrate, thereby being included in the cavity of the substrate.

The upper portion 110 of the LED lens 100 may function as an emitting surface through which light emitted from the LED chip and penetrating the phosphor layer may be emitted to an outside environment. That is, light may be emitted to an outside environment through the upper portion 110 of the LED lens 100.

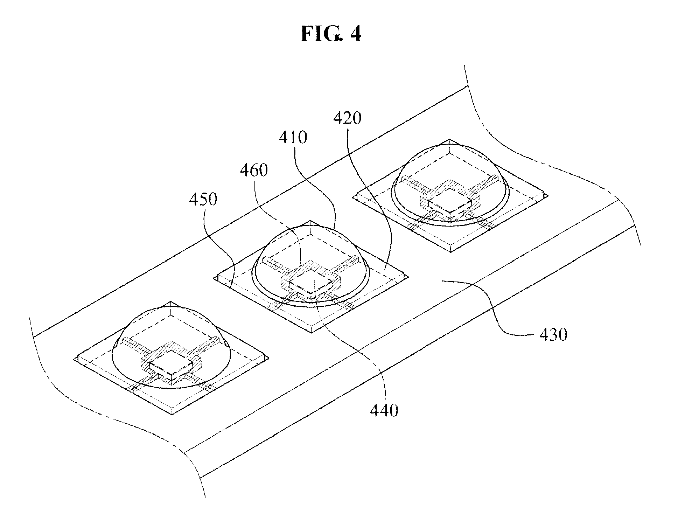

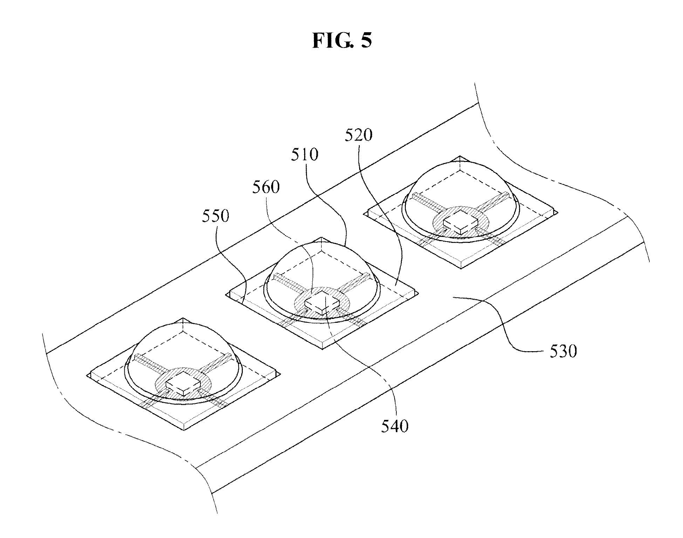

The upper portion 110 of the LED lens 100 may be provided in one of a hemispherical shape, an oval shape, and a batwing shape having a concave central portion. A shape of the upper portion 110 of the LED lens 100 may affect a control of an orientation angle and an implementation of a customized lens according to a predetermined application, which will be further described in a description directed to LED modules of FIG. 4 and FIG. 5.

Thus, an LED lens according to embodiments of the present invention may include a first depression and a second depression having predetermined patterns in a lower portion of the LED lens, and a phosphor layer and the LED lens may be collectively formed by disposing the LED lens after spraying a phosphor rather than separately forming the phosphor on the LED chip during a manufacture of the LED module.

An LED lens according to embodiments of the present invention may have an upper portion formed in advance in one of a hemispherical shape, an oval shape, and a batwing shape having a concave central portion, thereby implementing a customized lens according to a predetermined application.

According to embodiments of the present invention, an LED lens may be implemented to have a lower portion including a predetermined pattern for manufacturing a phosphor layer and an upper portion including various shapes conforming to a predetermined application.

FIG. 4 illustrates a portion of an LED module according to an embodiment of the present invention. FIG. 5 illustrates a portion of an LED module according to another embodiment of the present invention.

Referring to FIG. 4 and FIG. 5, LED modules according to embodiments of the present invention may include substrates 430 and 530, LED chips 440 and 540, phosphor layers 460 and 560, and lenses, respectively.

Hereinafter, descriptions will be directed to the LED module of FIG. 4. However, the descriptions may be similarly applied to an LED module of FIG. 5. Thus, a description of the substrate 430 may be similarly applied to the substrate 530, a description of the LED chip 440 may be similarly applied to the LED chip 540, a description of the phosphor layer 460 may be similarly applied to the phosphor layer 560, a description of a lower portion 420 of a lens may be similarly applied to a lower portion 520, a description of an upper portion 410 of the lens may be similarly applied to an upper portion 510, and a description of a cavity 450 may be similarly applied to a cavity 550.

The substrate 430 may be manufactured using metal, silicon, or ceramic. That is, the substrate 430 may be manufactured using a material having an excellent heat radiation characteristic. The cavity 450 may be formed on the substrate 430. The LED chip 440 may be mounted in the cavity 450.

The LED chip 440 may be mounted by a flip chip bonding scheme, and a solder or an adhesive having a conductive property may be used for the flip chip bonding scheme.

The LED chip 440 may be mounted on the substrate 430 by a die bonding scheme.

When an LED module is manufactured by a chip on module (COM) scheme according to an embodiment of the present invention, a wire bonding scheme may not be used for an electrical connection between the LED chip 440 and the substrate 430, and the LED chip 440 may be mounted on the substrate 430 in a flip chip form. That is, when the LED chip 440 is mounted in the flip chip form, LED chips may be densely mounted on the substrate 430, thereby decreasing a module size.

The LED chip 440 may include a first conductive semiconductor layer, an active layer, a second conductive semiconductor layer, and an electrode. Here, the first conductive semiconductor layer may include a III-V group compound. For example, the first conductive semiconductor layer may include gallium nitride (GaN), and is not limited thereto or restricted thereby.

The first conductive semiconductor layer may be n-doped. Here, n-doping indicates doping of a V group element, and an n-type impurity may include silicon (Si), germanium (Ge), selenium (Se), tellurium (Te), carbon (C), and the like. For example, the first conductive semiconductor layer may include n-GaN. An electron may be moved to the active layer through the first conductive semiconductor layer.

The active layer may be formed on the first conductive semiconductor layer. The active layer may be formed in a laminated structure in which a quantum barrier layer and a quantum well layer are alternately formed so that an electron and a hole may recombine and emit light. That is, the active layer may be formed in a single quantum well or multi-quantum wells. In this instance, a composition of the active layer may vary depending on a desired emission wavelength. For example, the quantum barrier layer may include GaN, and the quantum well layer may include indium gallium nitride (InGaN).

The second conductive semiconductor layer may be formed on the active layer. The second conductive semiconductor layer may include a III-V group compound. The second conductive semiconductor layer may be p-doped. Here, p-doping indicates doping of a III group element, and a p-type impurity may include magnesium (Mg), zinc (Zn), beryllium (Be), and the like. In particular, the second conductive semiconductor layer may be doped with a Mg impurity. For example, the second conductive semiconductor layer may include GaN. A hole may be moved to the active layer through the second conductive semiconductor layer.

A transparent electrode may be formed on the second conductive semiconductor layer. Here, the transparent electrode may be formed in a transparent metal layer such as nickel (Ni) / gold (Au) or be formed to include a conductive oxide such as indium tin oxide (ITO). A p-type electrode may be formed on the transparent electrode, and an n-type electrode may be formed on the first conductive semiconductor layer. As an example, the p-type electrode and the n-type electrode may include various conductive materials such as titanium (Ti) / aluminum (Al), and the like.

A hole may be provided through the p-type electrode, and an electron may be provided through the n-type electrode. The provided hole and the electron may combine in the active layer to generate light energy. In this instance, light may be emitted from the LED chip 440 including the active layer, and the LED chip 440 may correspond to an ultraviolet LED or a blue light LED depending on a wavelength of the emitted light.

The phosphor layer 460 may surround the LED chip 440. Since the phosphor layer 460 may surround the LED chip 440, light emitted from the LED chip 440 may proceed to the lens through the phosphor layer 460.

The phosphor layer 460 may scatter and color-convert light emitted from the LED chip 440. For example, blue light emitted from the LED chip 440 may be converted to yellow, green, or red light through the phosphor layer 460 and white light may be emitted to an outside environment.

The phosphor layer 460 may include a phosphor material capable of converting blue light to yellow, green, or red light. The phosphor layer 460 may include a host material and an active material, and include, for example, a cerium (Ce) active material in an yttrium aluminum garnet (YAG) host material. A europium (Eu) active material included in a silicate-based host material may be used for the phosphor layer 460, and is not limited thereto or restricted thereby.

The phosphor layer 460 may be formed to have a thin and uniform thickness as illustrated in FIG. 4. Phosphor particles may be uniformly distributed in the phosphor layer 460. Thus, light penetrating the phosphor layer 460 may be uniformly color-converted. By uniformly and evenly forming the phosphor layer 460, a phosphor distribution around the LED chip 440 may be uniform, and an optical design may be simplified through a surface emission.

When the phosphor layer 460 is formed to have a uniform thickness or width on an upper surface and a side surface of the LED chip 440 as illustrated in FIG. 4, a color dispersion may be reduced through a uniform conversion of light that is emitted from the LED chip.

When the phosphor layer 560 is formed to have the same radius of curvature as a radius of curvature of an upper surface of the lens as illustrated in FIG. 5, a luminance flux of light emitted from the LED chip 540 may be increased.

As described in the foregoing, a shape of the phosphor layer 460 may be formed to correspond to a shape of the first depression 121 as described with reference to FIGS. 1A and 1B, and vary depending on a type of a predetermined application.

The lens may include the upper portion 410 and the lower portion 420. The lower portion 420 of the lens may include a first depression that receives a phosphor on the LED chip 440 to form the phosphor layer 460 surrounding the LED chip 440 and a second depression that is connected to the first depression and functions as a passage for a portion of the phosphor to escape. A further description directed to the lower portion 420 of the lens will be omitted to avoid a repeated description.

Light emitted from the LED chip 440 and penetrating the phosphor layer 460 may be emitted outside through the upper portion 410 of the lens. Here, the upper portion 410 of the lens may be provided in one of a hemispherical shape, an oval shape, and a batwing shape having a concave central portion. A shape of the upper portion 410 of the lens may affect control of an orientation angle and an implementation of a customized lens according to a predetermined application.

A shape of the upper portion 410 of the lens may vary depending on various applications.

As an example, the upper portion 410 of the lens may be an oval shape. That is, a shape of the upper portion 410 of the lens may correspond to an ellipse in which a major axis and a minor axis have different lengths. When a backlight unit employing an edge type application is used, the upper portion 410 of the lens may be formed to be an oval shape so as to have an excellent rate of incidence in relation to a light guide plate.

The upper portion 410 of the lens may be in a batwing shape having a concave central portion. When a backlight unit or a module for flat lighting employing a direct type application is used, the upper portion 410 of the lens may have a radiation pattern in a batwing shape. In this instance, a relatively large area may be uniformly illuminated using a relatively small number of LEDs and a relatively thin LED module.

As an example, when a module for partial lighting is employed in an application, it may be appropriate for the upper portion 410 of the lens to have a radiation angle less than or equal to 60 degrees. That is, by employing the upper portion 410 of the lens having a narrow orientation angle, light may be illuminated in a relatively small area.

The upper portion 410 of the lens may have a shape different from an oval shape, and have symmetric cross sections or have a longest radius that is greater than a height of the lens. As another example, when a module for an L-tube lamp is employed in an application, it may be appropriate for the upper portion 410 of the lens to have a radiation angle greater than or equal to 150 degrees. That is, by employing the upper portion 410 of the lens having a wide orientation angle, light may be uniformly illuminated in a relatively large area.

As described in the foregoing, a shape of the upper portion 410 of the lens may vary according to various applications, and the shape may include a hemisphere, and the like as well as the aforementioned shapes.

An LED module according to an embodiment of the present invention may have an upper portion of a lens formed in advance in one of a hemispherical shape, an oval shape, and a batwing shape having a concave central portion, thereby implementing a customized lens according to a predetermined application.

According to an embodiment of the present invention, an LED lens may be implemented to have a lower portion including a predetermined pattern for manufacturing a phosphor layer and an upper portion including various shapes conforming to a predetermined application.

Hereinafter, a method of manufacturing an LED module according to an embodiment of the present invention will be described.

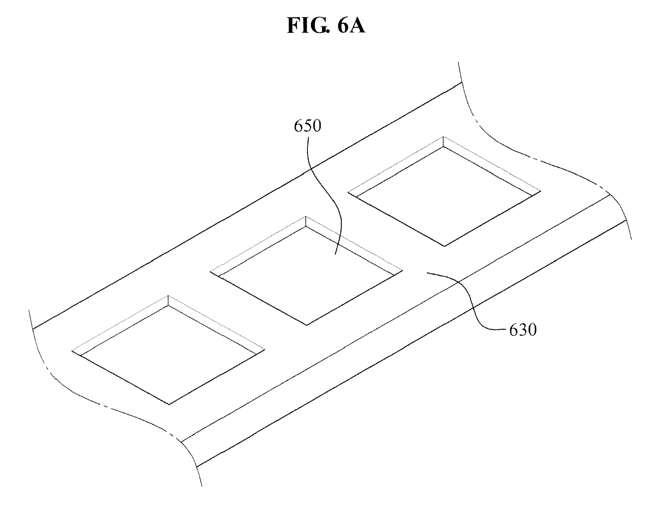

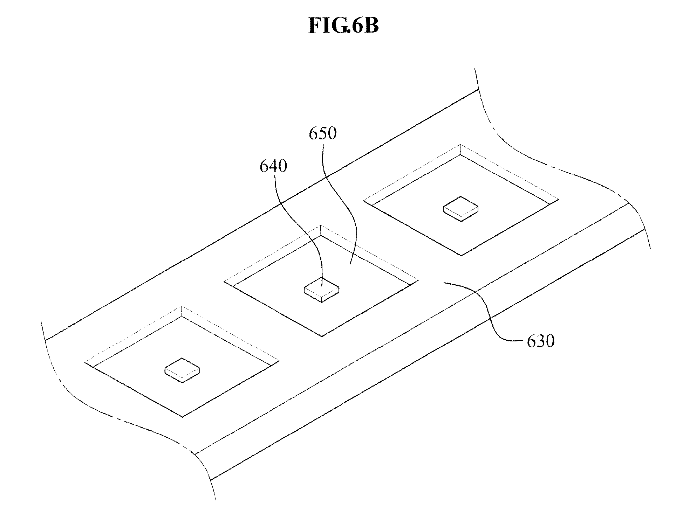

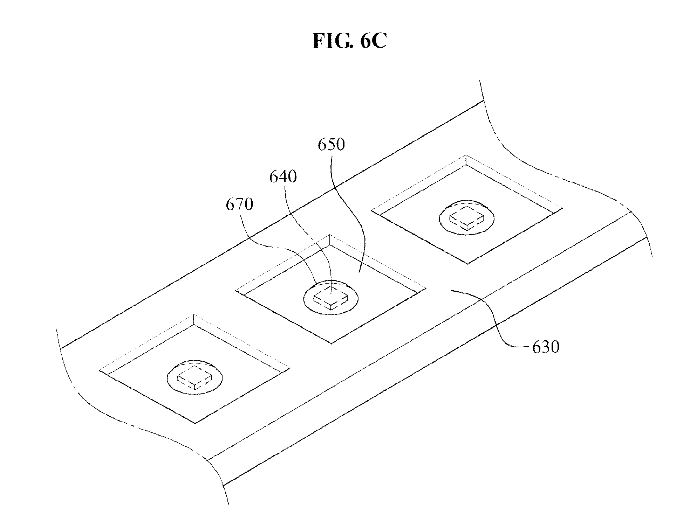

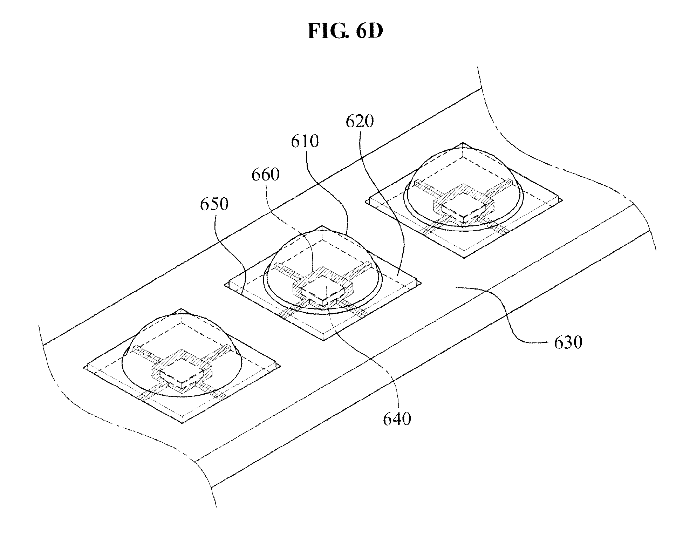

FIGS. 6A through 6D illustrate a method of manufacturing an LED module according to an embodiment of the present invention.

Referring to FIGS. 6A through 6D, a method of manufacturing an LED module according to an embodiment of the present invention may include forming a cavity 650 on a substrate 630, mounting an LED chip 640 in the cavity 650, spraying a phosphor 670 on the LED chip 640, disposing a lens including a first depression, that receives the phosphor 670 sprayed on the LED chip 640, and a second depression that is connected to the first depression and functions as a passage for a portion of the sprayed phosphor 670 to escape, in the cavity 650, and curing the phosphor 670 and the lens.

Initially, the cavity 650 may be formed on the substrate 630 to mount the LED chip 640. That is, the cavity 650 may be formed to be greater than a lower portion 620 of the lens.

Thereafter, the LED chip 640 may be directly mounted in the cavity 650 of the substrate 630 using various schemes. In this instance, a bump (not shown) may be disposed between the LED chip 640 and the substrate 630. Here, an adhesive having a conductive property, and the like may be used to directly mount the LED chip 640 in the cavity 650 of the substrate 630.

When an LED module is manufactured by a COM scheme according to an embodiment of the present invention, a wire bonding scheme may not be used for an electrical connection between the LED chip 640 and the substrate 630, and the LED chip 640 may be mounted on the substrate 630 in a flip chip form. That is, when the LED chip 640 is mounted in the flip chip form, LED chips may be densely mounted on the substrate 630, thereby decreasing a module size.

Thereafter, the phosphor 670 may be sprayed on the LED chip 640. A separate operation may be used to form a thin and uniform phosphor layer 660 after spraying the phosphor 670. However, according to an embodiment of the present invention, the phosphor layer 660 may be formed through the lens described below after spraying the phosphor 670.

An upper portion 610 and the lower potion 620 of the lens may have varying patterns to conform to a predetermined application. That is, a lens customized to conform to a predetermined application may be initially manufactured, and then disposed in the cavity 650 of the substrate 630.

In response to the lens being disposed in the cavity 650, the phosphor 670 may be received in the first depression, and an overflow of the phosphor 670 may escape through the second depression. Thus, a shape of the phosphor layer 660 may be determined depending on a shape of the first depression. In this instance, a plurality of second depressions, for example, the second depression may be formed to enable the overflow of the phosphor 670 to disperse and escape.

Thereafter, the LED module may be manufactured by curing the phosphor 670 and the lens. The phosphor layer 660 may be formed by curing silicon included in the phosphor 670 and the lens, and the lens may be directly formed on the substrate 630. In this instance, the phosphor 670 and the lens may be cured at a predetermined temperature profile. Here, the predetermined temperature profile may indicate a curing of silicon included in the phosphor 670 and the lens during a stepwise increase and decrease in temperature. The curing of silicon may be performed by dividing temperatures in a range of about 40 °C to 170 °C into intervals, and increasing and decreasing temperature to be on a predetermined interval. In the curing of silicon included in the phosphor 670 and the lens, a maximum temperature in the predetermined temperature profile may be in a range of about 150 °C to 200 °C.

As described in the foregoing, by applying a predetermined pattern to a lower portion of a lens, a phosphor layer may be formed concurrently with a lens that is directly formed on a substrate. That is, a shape of the lens to be applied may be formed in advance to conform to various applications.

As an example, a lens according to an embodiment of the present invention may include a first depression and a second depression having predetermined patterns in a lower portion of the lens, and a phosphor layer and the lens may be collectively formed by disposing the lens after spraying a phosphor rather than separately forming the phosphor on the LED chip during a manufacture of the LED module. Accordingly, a manufacturing tolerance, and the like on an LED module may be removed to improve yield, and a manufacturing process of the LED module may be simplified.

As another example, a lens according to an embodiment of the present invention may have an upper portion formed in advance in one of a hemispherical shape, an oval shape, and a batwing shape having a concave central portion, thereby implementing a customized lens according to a predetermined application.

According to an embodiment of the present invention, a lens may be implemented to have a lower portion including a predetermined pattern for manufacturing a phosphor layer and an upper portion including various shapes conforming to a predetermined application.

Although a few exemplary embodiments of the present invention have been shown and described, the present invention is not limited to the described exemplary embodiments. Instead, it would be appreciated by those skilled in the art that changes may be made to these exemplary embodiments without departing from the principles and spirit of the invention, the scope of which is defined by the claims and their equivalents.

## Claims

1. A light emitting device (LED) lens comprising:
a first depression to receive a phosphor on an LED chip to form a phosphor layer surrounding the LED chip; and
a second depression connected to the first depression and functioning as a passage for a portion of the phosphor to escape.

2. The LED lens of claim 1, wherein:
the first depression and the second depression are formed under the LED lens, and
an upper portion of the LED lens is formed in one of a hemispherical shape, an oval shape, and a batwing shape having a concave central portion.

3. The LED lens of claim 1, wherein the first depression is provided in a shape of one of a square cylinder, a cylinder, and a hemisphere.

4. The LED lens of claim 1, wherein second depressions are plural.

5. A light emitting device (LED) module comprising:
a substrate having a cavity;
an LED chip incorporated in the cavity;
a phosphor layer surrounding the LED chip; and
a lens including a first depression that receives a phosphor on an LED chip to form the phosphor layer and a second depression that is connected to the first depression and functions as a passage for a portion of the phosphor to escape.

6. The LED module of claim 5, wherein:
the first depression and the second depression are formed in a lower portion of the lens, and
an upper portion of the lens is formed in one of a hemispherical shape, an oval shape, and a batwing shape having a concave central portion.

7. The LED module of claim 5, wherein the first depression is provided in a shape of one of a square cylinder, a cylinder, and a hemisphere.

8. A manufacturing method of a light emitting device (LED) module, the method comprising:
forming a cavity on a substrate;
mounting an LED chip in the cavity;
spraying a phosphor on the LED chip;
disposing a lens including a first depression, that receives the phosphor sprayed on the LED chip, and a second depression that is connected to the first depression and functions as a passage for a portion of the sprayed phosphor to escape, in the cavity; and
curing the phosphor and the lens.

9. The method of claim 8, wherein the curing is performed at a predetermined temperature profile.

10. The method of claim 8, wherein second depressions are plural.
